# EUROPÄISCHE PATENTSCHRIFT

(11) **EP 1 834 516 B1**
(45) Veröffentlichungstag und Bekanntmachung des Hinweises auf die Patenterteilung: **27.02.2013**
(21) Anmeldenummer: 05825272.7
(22) Anmeldetag: 12.12.2005
(51) Int. Cl.: H05K 13/04

(54) **VERFAHREN ZUM BESTÜCKEN EINES BAUELEMENTETRÄGERS**
METHOD FOR EQUIPPING A COMPONENT SUPPORT
PROCEDE POUR EQUIPER UN SUPPORT DE COMPOSANTS

(30) Priorität: 04.01.2005 DE 102005000742
(43) Veröffentlichungstag der Anmeldung: 19.09.2007
(73) Patentinhaber: ASM Assembly Systems GmbH & Co. KG, 81379 München (DE)
(72) Erfinder: SCHIEBEL, Günter, 81379 München (DE)
(74) Vertreter: Dilg, Haeusler, Schindelmann Patentanwaltsgesellschaft mbH
(86) Internationale Anmeldenummer: PCT/EP2005/056669
(87) Internationale Veröffentlichungsnummer: WO 2006/072532

(56) Entgegenhaltungen:
- EP-A- 1 321 967
- WO-A-2004/059332
- US-A1- 2002 056 190
- US-B1- 6 282 779

## Beschreibung

Die Erfindung betrifft ein Verfahren zum Bestücken eines Bauelementeträgers mit Bauelementen, bei dem die zu bestückenden Bauelemente von einer Bauelement-Zuführeinrichtung mittels eines Bestückkopfes hin zu einem Bestückbereich transportiert und auf dem Bauelementeträger an vorgegebenen Bauelement-Einbauplätzen platziert werden.

Bei der Bestückung von Bauelementeträgern im Rahmen der sog. Surface-Mount-Technology (SMT) werden SMT-Bauelemente mittels eines Bestückkopfes von einer Abholposition einer Bauelement-Zuführeinrichtung abgeholt und an den vorgesehenen Bauelement-Einbauplätzen auf den Bauelementeträgern aufgesetzt. Unter dem Begriff Bauelementeträger wird im Folgenden jede Art von bestückfähigem Substrat, insbesondere Leiterplatten, verstanden. Unter dem Begriff Bauelement sind alle bestückfähigen Elemente zu verstehen, insbesondere zwei- oder mehrpolige SMT-Bauelemente oder andere hochintegrierte flächige Bauelemente wie beispielsweise Ball Grid Arrays, Bare Dies und Flip Chips. Ferner umfasst der Begriff Bauelement auch sog. RFID-Chips, welche für sog. Transponder verwendet werden.

Aufgrund der zunehmenden Miniaturisierung von elektronischen Baugruppen und des starken Preisdruckes auf dem Elektronikmarkt werden an moderne Bestückautomaten sowohl hinsichtlich der Bestückgenauigkeit als auch hinsichtlich der Bestückgeschwindigkeit hohe Anforderungen gestellt. Hohe Bestückgeschwindigkeiten führen dazu, dass insbesondere bei kleinen Bauelementen die mechanischen Belastungen, denen das Bauelement beim Aufsetzen auf einen Bauelementeträger ausgesetzt ist, so groß werden können, dass das Bauelement beschädigt wird. Die mechanische Belastung eines Bauelements bei einem schnellen Bestückprozess beruht darauf, dass selbst ein sehr sanft arbeitender Bestückkopf beim Aufsetzen auf das Bauelement eine statische Aufsetzkraft von zumindest 2 Newton ausübt. Selbst eine derart geringe Aufsetzkraft bewirkt bei kleinen Bauelementen, welche eine Kantenlänge im Bereich von 0,5 mm aufweisen, einen so hohen Aufsetzdruck, dass eine mechanische Beschädigung des Bauelements nicht zuverlässig ausgeschlossen werden kann. Durch eine Reduzierung der Aufsetzgeschwindigkeit könnten zwar die mechanischen Belastungen des Bauelements weiter reduziert werden, dies hätte jedoch eine negative Auswirkung auf die Bestückgeschwindigkeit und widerspricht somit der oben genannten Anforderung an einen modernen Bestückautomaten in Bezug auf die Bestückleistung. Unter dem Begriff Bestückleistung ist in diesem Zusammenhang die maximale Anzahl an Bauelementen zu verstehen, die innerhalb einer bestimmten Zeiteinheit bestückt werden können.

Ein weiteres Problem bei der herkömmlichen Bestückung insbesondere von kleinen Bauelementen ergibt sich aus der ungewollten Verformung von Materialdepots, welche üblicherweise auf den Bauelement-Anschlussflächen aufgebracht sind und welche der Fixierung und der dauerhaften Kontaktierung der bestückten Bauelemente an der Bestückposition dienen. So kann beispielsweise die Verformung von Lotpaste zu einem ungewollten Kurzschluss zwischen verschieden Anschlussflächen oder auch zu einer ungenügenden Verbindungsqualität zwischen den Anschlüssen von Bauelement und Bauelementeträger führen. Da die Verformung von Materialdepots von der Aufsetzgeschwindigkeit und dem Aufsetzdruck der mit einer bestimmten Aufsetzkraft in das Materialdepot gedrückten Bauelemente abhängt, tritt dieses Problem bei kleinen Bauelementen besonders stark auf und wird zukünftig mit einer zu erwartenden weiteren Miniaturisierung von Bauelementen immer wichtiger.

Der Erfindung liegt die Aufgabe zugrunde, ein Verfahren zum Bestücken eines Bauelementeträgers mit Bauelementen anzugeben, welches sowohl eine schnelle als auch eine schonende Bestückung ermöglicht.

Diese Aufgabe wird gelöst durch ein Verfahren mit den Merkmalen des unabhängigen Anspruchs 1. Gemäß der Erfindung wird ein Bauelement von einer Haltevorrichtung eines Bestückkopfes mittels einer von der Haltevorrichtung auf das Bauelement ausgeübten Haltekraft aufgenommen und nachfolgend von dem Bestückkopf an eine Abgabeposition oberhalb eines an dem Bauelementeträger vorgesehenen Bauelement-Einbauplatzes transportiert. Dabei weist die Abgabeposition einen vorbestimmten Abstand zu der Oberfläche des Bauelementeträgers auf. Zum Abgeben des Bauelements wird die Haltekraft abgeschaltet, so dass sich das Bauelement von der Haltevorrichtung ablöst und auf den Bauelementeträger transferiert wird.

Der vorbestimmte Abstand zwischen der Abgabeposition und der Oberfläche des Bauelementeträgers hängt dabei von mehreren Prozessparametern ab, welche spätestens im Lauf der Inbetriebnahme eines das erfindungsgemäße Verfahren ausführenden Bestückautomaten durch geeignete Testbestückungen ermittelt wird. Insbesondere hängt der Abstand von der Größe des zu bestückenden Bauelements ab, da sichergestellt werden muss, dass auch bei einem ungleichmäßigen Ablösen des Bauelements eine Verkantung verhindert wird. Auf diese Weise wird sicher gestellt, dass das Bauelement zuverlässig mit seiner vorgesehenen Unterseite auf dem zu bestückenden Bauelementeträger zum Liegen kommt.

Der Erfindung liegt die Erkenntnis zugrunde, dass ein derartiger quasi kontaktloser Transfer des Bauelements von der Haltevorrichtung auf den Bauelementeträger sowohl eine schnelle als auch eine das jeweilige Bauelement schonende Bestückung ermöglicht und somit sowohl eine preiswerte Herstellung von elektronischen Baugruppen als auch eine geringe Ausfallrate durch beschädigte oder schlecht bestückte Bauelemente ermöglicht.

Der Begriff kontaktloser Bauelement-Transfer ist dabei so zu verstehen, dass während des Aufsetzvorgangs das Bauelements nicht mit dem Bauelementeträger selbst in mechanischen Kontakt kommt, welcher üblicherweise eine sehr harte Unterlage darstellt. Dies umfasst mehrere mögliche Abgabeszenarien:
A) Abwerfen des Bauelements: Die Abgabeposition befindet sich in diesem Fall so weit oberhalb der Anschlussflächen des betreffenden Bauelement-Einbauplatzes, dass das Bauelement über das Medium Luft auf den Bauelementeträger abgegeben wird. Dies setzt ein mehr oder weniger gleichmäßiges Ablösen des Bauelements von der Haltevorrichtung voraus. Das Abwerfen kann beispielsweise durch die Schwerkraft und/oder durch magnetische bzw. elektrostatische Anziehungskräfte vermittelt bzw. unterstützt werden.
B) Absetzen des Bauelements: Die Abgabeposition befindet sich so knapp oberhalb der Anschlussflächen des betreffenden Bauelement-Einbauplatz, dass das Bauelement bereits vor dem Verlassen der Haltevorrichtung mit einem auf den vorgesehenen Bauelement-Anschlussflächen vorhandenen Materialdepot in Kontakt gekommen ist. Dies bedeutet, dass das Bauelement sanft in das im Vergleich zu dem Bauelementeträger sehr weiche Materialdepot eingedrückt wird.
C) Teilweises Absetzen bzw. Abwerfen des Bauelements: Die Abgabeposition befindet sich zwar oberhalb des Materialdepots, das Bauelement löst sich jedoch ungleichmäßig von der Haltevorrichtung ab. Dies kann dazu führen, dass bereits ein seitlicher Bereich des Bauelements mit einem ersten zur Kontaktierung vorgesehenen Materialdepot in Kontakt kommt, während die gegenüberliegende Seite des Bauelements die Haltevorrichtung noch berührt. Erst danach entfernt sich auch die gegenüberliegende Seite des Bauelements von der Haltevorrichtung und wird auf das entsprechende Materialdepot transferiert.

Das Verfahren nach Anspruch 2 wird dadurch realisiert, dass sich das Bauelement zunächst mit relativ hoher Geschwindigkeit auf den Bauelementeträger zu bewegt und in dem vorbestimmten Abstand zu der Oberfläche des Bauelementeträgers die Bewegung der Haltevorrichtung möglichst abrupt gestoppt wird. Somit wird das Bauelement mit einer Anfangsgeschwindigkeit, die der Bewegung der Haltevorrichtung unmittelbar vor dem Ablösen des Bauelements entspricht, auf den Bauelementeträger transferiert. Dabei muss jedoch sichergestellt werden, dass das Stoppen der Haltevorrichtung so abrupt erfolgt, dass das Bauelement nicht nach dem Abgeben durch ein Nachschwingen der Haltevorrichtung mit hoher Kraft unkontrolliert in das Materialdepot gedrückt wird.

Gemäß Anspruch 3 wird als Haltevorrichtung eine Saugpipette verwendet, welche die Haltekraft mittels eines Unterdrucks erzeugt. Das Ablösen des Bauelements wird dabei durch ein abruptes Abkoppeln des Unterdrucks und durch ein möglichst schlagartiges Ankoppeln eines Überdrucks an die Saugpipette unterstützt. Durch ein derartiges pneumatisch unterstütztes Transferieren des Bauelements auf den Bauelementeträger wird sowohl die Geschwindigkeit als auch die Genauigkeit des Bauelement-Transfers erhöht. Die pneumatische Unterstützung des Bauelement-Transfers kann auf einfache Weise realisiert werden, da die Saugpipetten von einigen herkömmlichen Bestückautomaten bereits mit einer schaltbaren Pneumatikeinrichtung versehen sind, welche das Umschalten von einem Unterdruck auf einen Überdruck ermöglichen. Es wird darauf hingewiesen, dass pneumatische Schaltvorgänge stets einer gewissen Trägheit unterliegen, so dass ein entsprechendes Umschaltventil, welches üblicherweise von der Saugpipette beabstandet ist, bereits vor dem Erreichen der Abgabeposition angesteuert werden kann.

Gemäß Anspruch 4 wird im Vorfeld der Bestückung das genaue Oberflächenprofil des Bauelementeträgers mittels eines Abstandssensors vermessen. Dazu können sowohl elektromechanische Messtaster, welche heutzutage eine Genauigkeit in der Größenordnung von 1µm aufweisen, als auch bevorzugt optische Abstandssensoren verwendet werden, welche den elektromechanische Messtastern in Bezug auf die Messgeschwindigkeit deutlich überlegen sind. Als optische Abstandssensoren eignen sich insbesondere auf dem Messprinzip der Laser-Triangulation beruhende Sensoren, welche das Höhenprofil durch eine Lageerfassung der Zielpunkte zweier Laserstrahlen ermitteln, die aus unterschiedlichen Einfallsrichtungen auf die zu vermessende Oberfläche auftreffen. Durch die Vermessung des Oberflächenprofils können variable Höhenpositionen der auf dem Bauelementeträger vorhandenen Bauelement-Einbauplätze genau bestimmt werden, so dass auch bei einer beispielsweise durch mechanische Verspannungen verursachten Wölbung des zu bestückenden Bauelementeträgers die Länge der Transferstrecke des Bauelements von der Haltevorrichtung hin zu dem Bauelementeträger stets gleich gehalten werden kann. Dies trägt in besonderem Maße zu einer Erhöhung der Prozesssicherheit bei.

Die Oberflächenvermessung des Bauelementeträgers kann dabei dadurch erfolgen, dass entweder ein den Abstandssensor aufweisendes Höhenmeßsystem oberhalb des Bauelementeträgers verfahren und somit das Oberflächenprofil abtastet wird oder dass der Bauelementeträger unterhalb eines feststehenden Höhenmeßsystems positioniert und derart bewegt wird, dass zumindest an den vorgesehenen Bauelement-Einbauplätzen die Höhenlage der Oberfläche des Bauelementeträgers erfasst wird.

Das Verfahren nach Anspruch 5, bei dem das Oberflächenprofil durch eine Interpolation zwischen diskreten Oberflächenprofil-Messwerten ermittelt wird, hat den Vorteil, dass die Oberflächenvermessung schnell und trotzdem mit hoher Genauigkeit durchgeführt werden kann.

Gemäß Anspruch 6 wird mittels eines als Abstandsschalter ausgebildeten konfokalen Abstandssensors der Zeitpunkt erfasst, an dem sich das Bauelement in der Abgabeposition befindet. Ein geeigneter konfokaler Abstandsschalter ist beispielsweise in der deutschen Patentschrift DE 101 45 167 C2 offenbart: Dieser Abstandsschalter umfasst einen Lichtwellenleiter, dessen eines Ende sowohl mit einer Sendeeinheit zum Aussenden von Licht als auch mit einer Empfangseinheit zum Empfangen von Licht gekoppelt ist. An dem anderen Ende des Lichtwellenleiters ist eine Endfläche ausgebildet, welche somit sowohl zum Aussenden als auch zum Empfangen von Licht eingerichtet ist. Der Abstandsschalter umfasst ferner eine Abbildungsoptik, welche die Lichtwellenleiter-Endfläche auf einen räumlichen Schaltbereich abbildet, sowie eine Ausgabeeinrichtung, welche mit dem Lichtempfänger gekoppelt ist. Die Ausgabeeinrichtung ist derart eingerichtet, dass ein Signal ausgegeben wird, wenn sich ein zumindest teilweise reflektierendes Objekt in den Schaltbereich bewegt und somit von der Lichtwellenleiter-Endfläche ausgesandtes Licht mit einer bestimmten Mindestintensität auf die Lichtwellenleiter-Endfläche zurück reflektiert wird.

Zum genauen Erkennen der Abgabeposition mittels des genannten konfokalen Abstandsschalters wird die Lichtwellenleiter-Endfläche und die Optik des Abstandsschalters an dem Bestückkopf bzw. an der Haltevorrichtung angebracht und derart justiert, dass beim Absenken der Haltevorrichtung in Richtung des Bauelementeträgers der Abstandsschalter gerade dann ein Signal ausgibt, wenn der relativ zu der Haltevorrichtung in einer festen räumlichen Lage befindliche Schaltbereich auf die Oberfläche des Bauelementeträgers trifft.

Bevorzugt wird der Abstandsschalter derart justiert, dass er bereits ein Signal ausgibt, wenn sich das Bauelement kurz vor der Abgabeposition befindet. Auf diese Weise können zeitliche Verzögerungen berücksichtigt und entsprechend kompensiert werden, welche durch eine stets vorhandene Reaktionszeit insbesondere zum vollständigen Anhalten der Haltevorrichtung und zum Abschalten der Haltekraft verursacht werden.

Der Abstandsschalter ist bevorzugt relativ zu dem Bestückkopf parallel zu der Oberfläche des zu bestückenden Bauelementeträgers verschiebbar befestigt. Auf diese Weise kann sichergestellt werden, dass der Schaltbereich des Abstandsschalters nicht auf eine zufällige Erhebung des Bauelementeträgers wie beispielsweise ein bereits bestücktes Bauelement trifft und somit bei einer völlig falschen Höhenposition ein Signal zur Bauelement-Abgabe ausgegeben wird.

Weitere Vorteile und Merkmale der vorliegenden Erfindung ergeben sich aus der folgenden beispielhaften Beschreibung einer derzeit bevorzugten Ausführungsvariante.

In der Zeichnung zeigen in schematischen Darstellungen
- Figur 1: den Aufsetzvorgang eines Bauelements auf einen Bauelementeträger gemäß dem Stand der Technik,
- Figur 2: den quasi kontaktlosen Aufsetzvorgang eines Bauelements auf einen Bauelementeträger gemäß einer Ausführungsvariante der Erfindung,
- Figur 3: das Geschwindigkeitsprofil einer Haltevorrichtung beim Aufsetzen eines Bauelements gemäß dem Stand der Technik und beim Abgeben eines Bauelements gemäß einer Ausführungsvariante der Erfindung und
- Figur 4: die Vermessung des Oberflächenprofils eines zu bestückenden Bauelementeträgers.

An dieser Stelle bleibt anzumerken, dass sich in der Zeichnung die Bezugszeichen einander entsprechender Komponenten lediglich in ihrer ersten Ziffer unterscheiden.

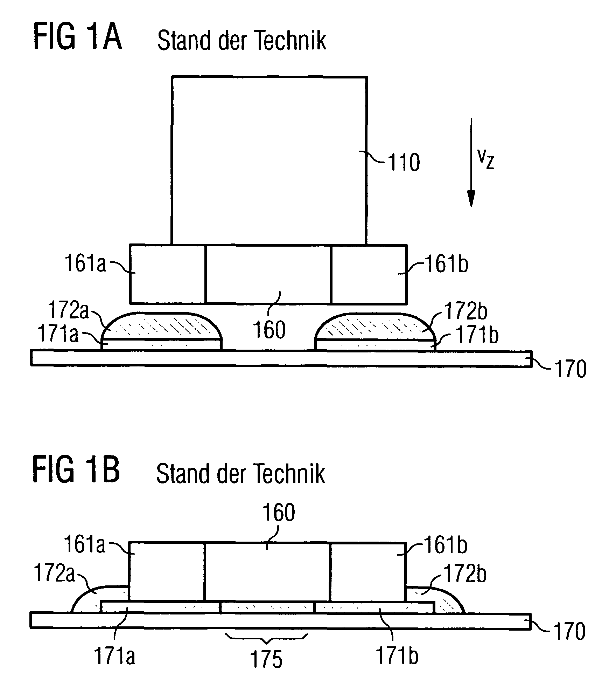

Wie aus den Figuren 1a und 1b ersichtlich, erfolgt der aus dem Stand der Technik bekannte Aufsetzvorgang eines Bauelements 160 auf eine Leiterplatte 170 dadurch, dass eine das Bauelement 160 aufnehmende Saugpipette 110 mit einer durch den Pfeil dargestellten Geschwindigkeit v_{z} in Richtung der Leiterplatte 170 bewegt wird. Das Bauelement 160 wird an einem vorgegebenen Bauelement-Einbauplatz aufgesetzt, so dass Anschlusskontakte 161a bzw. 161b des Bauelements 160 in Materialdepots 172a bzw. 172b gedrückt werden. Die Materialdepots 172a, 172b, welche auf Anschlussflächen 171a bzw. 171b der Leiterplatte 170 aufgebracht sind, enthalten beispielsweise Lotpaste, so dass nach der Bestückung des Bauelements 160 durch einen Lötvorgang ein dauerhafter elektrischer Kontakt zwischen dem Anschlusskontakt 171a und der Anschlussfläche 171a sowie zwischen dem Anschlusskontakt 161b und der Anschlussfläche 171b gewährleistet ist.

Abhängig von der Aufsetzkraft bzw. von dem zeitlichen Verlauf der Geschwindigkeit v_{z} wird, wie aus Figur 1b ersichtlich, das Bauelement 160 mehr oder weniger tief in die Materialdepots 172a, 172b eingedrückt. Dies führt zu einer partiellen räumlichen Verdrängung der Materialdepots 172a, 172b, so dass sich insbesondere bei kleinen Bauelementen mit nahe voneinander beabstandeten Anschlussflächen 171a und 171b die verformten Materialdepots 172a und 172b so nahe kommen, dass in einem Bereich 175 zwischen den beiden Anschlussflächen 171a und 171b Material gedrückt wird und ein Kurzschluss entsteht. Dies führt in der Regel zu einer späteren Fehlfunktion einer auf der Leiterplatte 170 ausgebildeten elektronischen Baugruppe, so dass die betreffende Leiterplatte 170 zur Herstellung von elektronischen Geräten entweder repariert oder nicht mehr verwendet werden kann und als Elektronikschrott entsorgt werden muss.

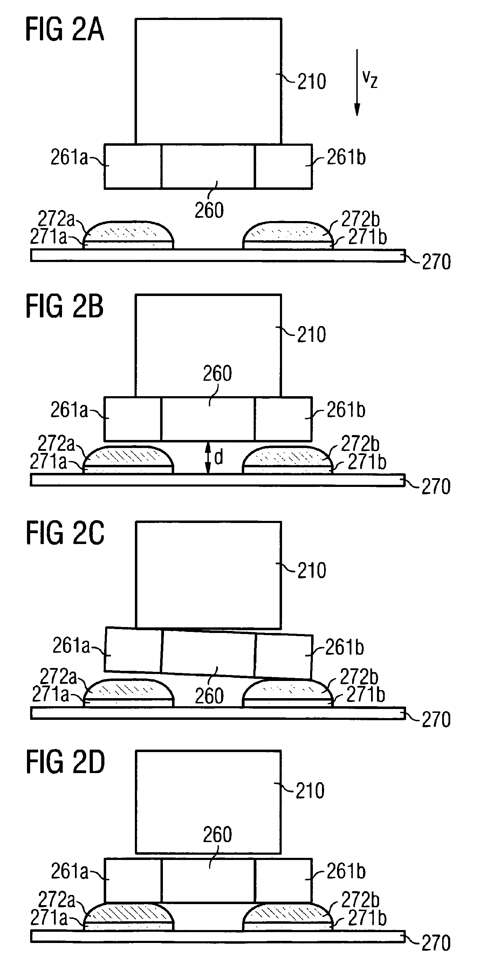

Das quasi kontaktlose Bestücken gemäß einer Ausführungsform der Variante der Erfindung ist in den Figuren 2a, 2b, 2c und 2d dargestellt. Wie aus Figur 2a ersichtlich, beginnt das kontaktlose Bestücken dadurch, dass ein Bauelement 260, welches zwei Anschlusskontakte 261a bzw. 261b aufweist, von einer Saugpipette 210 gehalten mit einer Geschwindigkeit v_{z} in Richtung einer zu bestückenden Leiterplatte 270 bewegt wird. Auf der Leiterplatte 270 sind zwei Anschlussflächen 271a und 271b vorgesehen, welche mit den Anschlusskontakten 261a und 261b in elektrischen Kontakt gebracht werden sollen. Auf der Anschlussfläche 271a bzw. 271b ist ein Lotdepot 272a bzw. 272b aufgetragen, welches in bekannter Weise für einen nachfolgenden Lotvorgang zur dauerhaften Kontaktierung zwischen jeweils einem Anschlusskontakt 261a bzw. 261b und einer Anschlussfläche 271a bzw. 271b benötigt wird.

Wie aus Figur 2b ersichtlich, wird die Bewegung des Bauelements 260 bzw. der Haltevorrichtung 210 gerade dann gestoppt, wenn sich das Bauelement 260 in einem vorbestimmten Abstand d oberhalb der Leiterplatte 270 befindet.

Mit dem Erreichen der Abgabeposition des Bauelements 260 wird ein Unterdruck, mit dem das Bauelement 260 von der Haltevorrichtung 210 gehalten wird, abgeschaltet und Blasluft durch die nicht dargestellten Saugkanäle der Saugpipette 210 geblasen. Das Umschalten des Unterdrucks auf einen die Blasluft erzeugenden Überdruck erfolgt in bekannter Weise in einem hier nicht dargestellten Pneumatiksystem, welches ein schnell schaltbares Pneumatik-Ventil aufweist.

Das Umschalten von Unterdruck auf Überdruck bewirkt ein Ablösen des Bauelements 260 von der Saugpipette 210, welches häufig nicht gleichmäßig, sondern in der in Figur 2c dargestellten Art und Weise erfolgt. Dabei verliert zunächst ein seitlicher Teil des Bauelements 260 den Kontakt zu der Haltevorrichtung 210, so dass sich das Bauelement 260 in einer schrägen Stellung innerhalb des Zwischenraums zwischen der Haltevorrichtung 210 und den beiden Lotdepots 272a, 272b befindet.

Infolge der aus der Saugpipette 210 nach unten ausströmenden Blasluft wird unmittelbar nach dem ersten Ablösen des Bauelements 260 auch die andere Seite des Bauelements den Kontakt mit der Saugpipette 210 verlieren und auf dem Lotdepot 272a aufsetzen. Damit ist die Bestückung des Bauelements 260 beendet und das Bauelement 260 verbleibt infolge einer gewissen Klebrigkeit der Lotdepots 272a, 272b in der gewünschten Einbauposition, die in Figur 2d dargestellt ist.

Im Vergleich zu dem oben anhand von Figur 1 erläuterten kontaktbehafteten Bestücken ist der Druck, den das kontaktlos bestückte Bauelement 260 auf die Lotdepots 272a, 272b ausübt, deutlich reduziert. Dies bewirkt, dass die Form der Lotdepots 272a, 272b durch das Bauelement 260 kaum verändert wird und ein Kurzschluss zwischen den Anschlussflächen 271a 271b infolge eines mechanischen Kontaktes zwischen deformierten Lotdepots zuverlässig verhindert wird.

Das kontaktlose Bestücken hat zudem den Vorteil, dass das Bauelement 260 nicht einer gewissen Mindest-Aufsetzkraft der Saugpipette 210 unterworfen ist, welche insbesondere bei kleinen Bauelementen zu hohen Drücken und damit auch zu einer mechanischen Beschädigung, beispielsweise zu einem Zerbrechen des Bauelements 260 führen kann.

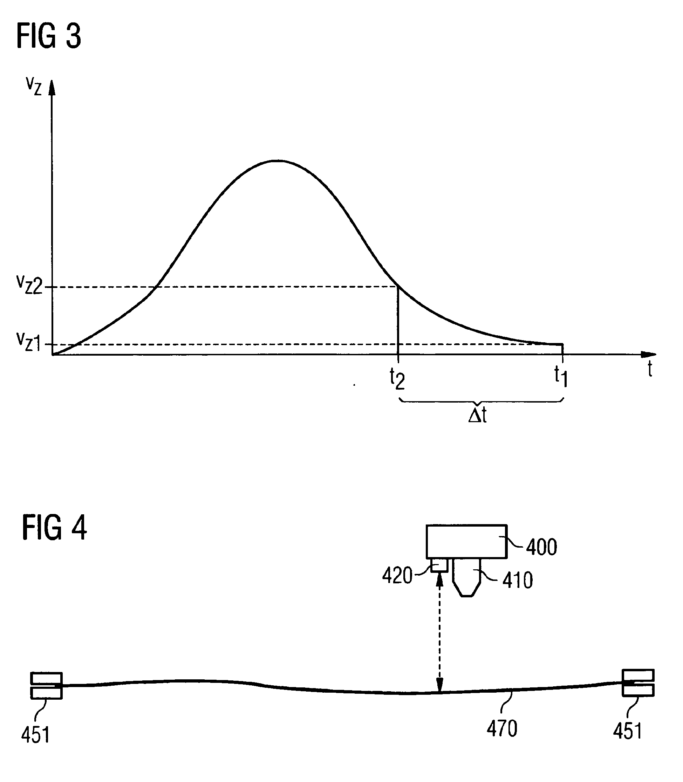

Figur 3 zeigt ein typisches Geschwindigkeitsprofil, mit dem eine ein Bauelement haltende Saugpipette während eines Bestückvorgangs senkrecht zu der Oberfläche eines Bauelementeträgers in Richtung des Bauelementeträgers bewegt wird. Um einen zügigen Bauelement-Transfer zu ermöglichen, wird die Saugpipette zunächst in Richtung des Bauelementeträgers (im allgemeinen nach unten) beschleunigt und nach dem Erreichen einer maximalen Geschwindigkeit v_{z} wieder abgebremst, um ein hartes Aufprallen des Bauelements auf den Bauelementeträger zu verhindern. Bei einem aus dem Stand der Technik bekannten kontaktbehafteten Bestückvorgang wird die Geschwindigkeit v_{z} der Saugpipette bis hin zu einem Wert v_{z1} reduziert, um beim Aufsetzen des Bauelements zu einem Zeitpunkt t₁ eine mechanische Beschädigung zu verhindern (Minimierung des Stosses).

Im Gegensatz dazu erlaubt das kontaktlose Transferieren des Bauelements ein Anfahren der Abgabeposition, welche sich in einem bestimmten Abstand oberhalb des Bauelementeträgers befindet, mit einer im Vergleich zu v_{z1} deutlich größeren Geschwindigkeit v_{z2}. Beim Erreichen der Abgabeposition zu einem Zeitpunkt t₂ wird die Saugpipette möglichst abrupt angehalten und das Bauelement abgegeben. Aufgrund der mechanischen Trägheit des Bauelements hat dieses das Bestreben, die Saugpipette mit der Geschwindigkeit v_{z2} in Richtung des Bauelementeträgers zu verlassen. Durch den kontaktlosen Bauelement-Transfer kann somit für die letzte Phase des Bestückvorgangs eine Zeitersparnis Δt erzielt werden, welche sich aus der Differenz zwischen der beiden Zeiten t₁ und t₂ ergibt. Damit ermöglicht das kontaktlose Bestücken nicht nur eine besonders schonende Behandlung des Bauelementes sondern auch eine signifikante Erhöhung der Bestückleistung.

Eine hohe Prozesssicherheit beim kontaktlosen Bestücken wird dadurch realisiert, dass vor dem eigentlichen Bestückvorgang des Oberflächenprofil einer Leiterplatte 470, welche üblicherweise mittels Halteklemmen 451 in einem Bestückbereich eines Bestückautomaten fixiert ist, genau vermessen wird. Dazu kann bevorzugt ein optischer Abstandssensor 420 verwendet werden, welcher neben einer Saugpipette 410 an einem Bestückkopf 400 angebracht ist. Somit kann auf einfache Weise das Oberflächenprofil in dem Zustand abgetastet werden, in dem sich die zu bestückende Leiterplatte 470 während eines nachfolgenden Bestückvorgangs befindet. Die durch die Oberflächenprofilvermessung ermittelten Höhenwerte werden in einer nicht dargestellten Steuereinheit gespeichert und beim Anfahren der Saugpipette 410 an die jeweils den Abgabepositionen entsprechenden Positionen berücksichtigt.

Es kann jedoch auch auf eine vorherige Vermessung des Oberflächenprofils der Leiterplatte 470 verzichtet werden, wenn der Abstandssensor 420 die Bewegung der Saugpipette 410 triggert. Dies kann beispielsweise dadurch realisiert werden, dass der Abstandssensor 420 als Abstandsschalter ausgebildet ist, welcher genau dann ein Signal ausgibt, wenn sich die nach unten bewegende Saugpipette 410 in einem bestimmten Abstand von einem vorgesehenen Einbauplatz oberhalb der Leiterplatte 470 befindet.

Zusammenfassend bleibt festzustellen: Die Erfindung schafft ein Verfahren zum Bestücken eines Bauelementeträgers 270 mit Bauelementen 260, bei dem ein Bauelement 260 von einer Haltevorrichtung 210 eines Bestückkopfes mittels einer von der Haltevorrichtung 210 auf das Bauelement 260 ausgeübten Haltekraft aufgenommen wird. Das aufgenommene Bauelement 260 wird von dem Bestückkopf an eine vorgegebene Abgabeposition oberhalb eines an dem Bauelementeträger 270 vorgesehenen Bauelement-Einbauplatzes transportiert. Bei Erreichen der Abgabeposition wird die Haltekraft abgeschaltet, so dass sich das Bauelement 260 von der Haltevorrichtung 210 ablöst und auf den Bauelementeträger 270 transferiert wird. Die Prozesssicherheit des Bauelemente-Transfers kann dadurch erhöht werden, dass das Ablösen des Bauelements 260 während eines möglichst abrupten Abbremsens der Haltevorrichtung 210 erfolgt, so dass der Bauelement-Transfer durch die mechanische Trägheit des Bauelements 210 unterstützt wird. Zusätzlich kann der Ablösevorgang des Bauelementes 260 von einer als Haltevorrichtung dienenden Saugpipette 210 durch ein pneumatisches Schaltventil unterstützt werden, welches einen Unterdruck, mit dem das Bauelement 260 an der Saugpipette 210 gehalten wird, auf einen Überdruck umschaltet, welche durch Blasluft das Abgeben des Bauelementes 260 unterstützt.

### Bezugszeichenliste

- 110: Saugpipette
- 160: Bauelement
- 161a: Anschlusskontakt
- 161b: Anschlusskontakt
- 170: Leiterplatte
- 171a: Anschlussfläche
- 171b: Anschlussfläche
- 172a: Materialdepot
- 172b: Materialdepot
- 175: Zwischenbereich

- 210: Saugpipette
- 260: Bauelement
- 261a: Anschlusskontakt
- 261b: Anschlusskontakt
- 270: Leiterplatte
- 271a: Anschlussfläche
- 271b: Anschlussfläche
- 272a: Materialdepot
- 272b: Materialdepot
- d: Abstand Bauelement - Leiterplatte

- t1: Aufsetzzeitpunkt (Stand der Technik)
- v_{z1}: Geschwindigkeit vor Abbremsen (Stand der Technik)
- t2: Abgabezeitpunkt
- v_{z2}: Geschwindigkeit vor Abbremsen
- Δt: Zeitersparnis beim kontaktlosen Bestücken

- 400: Bestückkopf
- 410: Saugpipette
- 420: Abstandssensor
- 451: Halteklemmen
- 470: Leiterplatte

## Patentansprüche

1. Verfahren zum Bestücken eines Bauelementeträgers mit Bauelementen, bei dem
• ein zu bestückendes Bauelement (260) von einer Haltevorrichtung (210, 410) eines Bestückkopfes (400) mittels einer von der Haltevorrichtung (210, 410) auf das Bauelement (260) ausgeübten Haltekraft aufgenommen wird,
• das aufgenommene Bauelement (260) von dem Bestückkopf (400) an eine Abgabeposition oberhalb eines an dem Bauelementeträger (270, 470) vorgesehenen Bauelement-Einbauplatzes transportiert wird, wobei die Abgabeposition einen vorbestimmten Abstand zu der Oberfläche des Bauelementeträgers (270, 470) aufweist und wobei in der Abgabeposition das zu bestückende Bauelement (260) frei von einem mechanischen Kontakt mit dem Bauelementeträger ist, und
• die Haltekraft abgeschaltet wird, so dass sich zumindest ein Teil des in der Abgabeposition befindlichen Bauelements (260) von der Haltevorrichtung (210, 410) ablöst und kontaktlos über das Medium Luft auf den Bauelementeträger (270, 470) transferiert wird.

2. Verfahren nach Anspruch 1, bei dem
das Ablösen des Bauelements (260) durch eine abrupte Änderung der Geschwindigkeit der Haltevorrichtung (210, 410) unterstützt wird, wenn sich das Bauelement (260) in der Abgabeposition befindet.

3. Verfahren nach einem der Ansprüche 1 bis 2, bei dem
• als Haltevorrichtung eine Saugpipette (210, 410) verwendet wird, welche die Haltekraft mittels eines Unterdrucks erzeugt, und
• das Ablösen des Bauelements (260) durch ein abruptes Abkoppeln des Unterdruck und das Ankoppeln eines Überdrucks unterstützt wird.

4. Verfahren nach einem der Ansprüche 1 bis 3, bei dem im Vorfeld der Bestückung das genaue Oberflächenprofil des Bauelementeträgers (270, 470) mittels eines Abstandssensors vermessen wird.

5. Verfahren nach Anspruch 4, bei dem das Oberflächenprofil durch eine Interpolation zwischen diskreten Oberflächenprofil-Messwerten ermittelt wird.

6. Verfahren nach einem der Ansprüche 1 bis 5, bei dem mittels eines als Abstandsschalter (420) ausgebildeten konfokalen Abstandssensors erfasst wird, wann sich das Bauelement (260) in der Abgabeposition befindet.

## Claims

1. Method for assembling a component carrier with components, wherein
a component (260) to be assembled is collected from a holding apparatus (210, 410) of an assembly head (400) by a holding force, which is applied to the component (260) via the holding apparatus (210, 410),
the collected component (260) is transported by the assembly head (400) to a deposit position above a component-mounting location, which is provided at the component carrier (270, 470), wherein the deposit position comprises a predetermined distance to the surface of the component carrier (270, 470), and wherein in the deposit position the component (260) to be assembled is free of a mechanical contact with the component carrier, and
the holding force is switched off such as at least a part of the component (260) which is located in the deposit position detaches from the holding apparatus (210, 410) and is transferred onto the component carrier (270, 470) via the medium of air in a contactless manner.

2. Method according to claim 1, wherein
the detaching of the component (260) is supported via a abrupt change of the velocity of the holding apparatus (210, 410), if the component (260) is located in the deposit position.

3. Method according to one of the claims 1 to 2, wherein
a suction pipette (210, 410) is used as the holding apparatus, which generates the holding force by a negative pressure, and
the detaching of the component (260) is supported via a abrupt decoupling of the negative pressure and coupling of a positive pressure.

4. Method according to one of the claims 1 to 3, wherein
in preparation of the assembling the precise surface profile of the component carrier (270, 470) is measured by a distance sensor.

5. Method according to claim 4, wherein
the surface profile is determined by an interpolation between discrete surface profile measuring values.

6. Method according to claims 1 to 5, wherein
a confocal distance sensor which is formed as a distance switch (420) detects when the component (260) is located in the deposit position.

## Revendications

1. Procédé servant à équiper un support de composants avec des composants, dans le cadre duquel
- un composant (260) destiné à équiper est logé par un dispositif de maintien (210, 410) d'une tête d'équipement (400) au moyen d'une force de maintien exercée par le dispositif de maintien (210, 410) sur le composant (260),
- le composant (260) logé est transporté par la tête d'équipement (400) à une position de dégagement au-dessus d'un emplacement de montage pour composant prévu au niveau du support de composants (270, 470), sachant que la position de dégagement présente une distance prédéfinie par rapport à la surface du support de composants (270, 470) et sachant que le composant (260) destiné à équiper est exempt de tout contact mécanique avec le support de composants dans la position de dégagement, et
- la force de maintien est mise hors circuit si bien qu'au moins une partie du composant (260) se trouvant dans la position de dégagement est détachée par le dispositif de maintien (210, 410) et est transférée sans contact sur le support de composants (270, 470) par l'intermédiaire du milieu de l'air.

2. Procédé selon la revendication 1, dans le cadre duquel
le détachement du composant (260) est soutenu par une modification brutale de la vitesse du dispositif de maintien (210, 410), lorsque le composant (260) se trouve dans la position de dégagement.

3. Procédé selon l'une quelconque des revendications 1 à 2, dans le cadre duquel
- on utilise comme dispositif de maintien une pipette d'aspiration (210, 410), qui génère la force de maintien au moyen d'une pression basse, et
- le détachement du composant (260) est soutenu par un désaccouplement brutal de la pression basse et par l'accouplement d'une surpression.

4. Procédé selon l'une quelconque des revendications 1 à 3, dans le cadre duquel
en amont de l'équipement, on mesure avec précision au moyen d'un capteur de distance le profil de surface du support de composants (270, 470).

5. Procédé selon la revendication 4, dans le cadre duquel
le profil de surface est déterminé par une interpolation entre les valeurs discrètes de mesure du profil de surface.

6. Procédé selon l'une quelconque des revendications 1 à 5, dans le cadre duquel
on détecte au moyen d'un capteur de distance confocal réalisé comme un commutateur à distance (420) si le composant (260) se trouve dans la position de dégagement.
